(19) Europäisches Patentamt
European Patent Office
Office européen des brevets

(11) Publication number: **0 133 351 B1**

# (12) EUROPEAN PATENT SPECIFICATION

(45) Date of publication of patent specification: **18.05.88**

(51) Int. Cl.⁴: **C 09 K 11/06**

(21) Application number: **84304917.2**

(22) Date of filing: **19.07.84**

## (54) Control of circuit board quality.

(30) Priority: **29.07.83 US 518455**

(43) Date of publication of application: **20.02.85 Bulletin 85/08**

(45) Publication of the grant of the patent: **18.05.88 Bulletin 88/20**

(84) Designated Contracting States: **DE FR NL**

(56) References cited:
**FR-A-2 261 321**
**GB-A-1 142 504**

(73) Proprietor: **AMERICAN TELEPHONE AND TELEGRAPH COMPANY**
**550 Madison Avenue**
**New York, NY 10022 (US)**

(72) Inventor: **Chandross, Edwin Arthur**
**14 Hunterdon Boulevard**
**Berkeley Heights New Jersey 07974 (US)**

(74) Representative: **Johnston, Kenneth Graham et al**
**Western Electric Company Limited**
**5 Mornington Road**
**Woodford Green Essex, IG8 OTU (GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

EP 0 133 351 B1

**Description**

Background of the Invention

1. *Field of the Invention*

This invention relates to electronic equipment and, in particular, to printed circuit boards.

2. *Art Background*

Printed circuit boards are widely used in electronic equipment. In such boards generally a metallic, e.g., copper, pattern is produced on a polymer substrate. The substrates are typically fabricated by spraying a lacquer including the desired resin, for example, an epoxy resin, onto a reinforcing grid such as a fiber glass mesh. A variety of methods are employed to produce the copper pattern. These methods typically involve a lithographic process and a wet etching process which, although quite reliable, sometimes yield irregularities in the desired pattern. For example, discontinuities or width narrowing or broadening in metallic pattern lines are encountered. Such irregularities often lead to the degradation of component properties and ultimately to equipment failure.

It is desirable to detect irregularities before further processing occurs. After the metal pattern is produced, electronic components are affixed to the pattern through various expedients such as soldering. Obviously, if the pattern produces a failure after the components are affixed, a large expense is incurred in either replacing the board or, alternatively, in discovering the point of failure and repairing it. In contrast, if the irregularity is detected before affixing of the electronic components, the relatively inexpensive board is either discarded or expeditiously repaired.

Various ways have been investigated to determine the presence of pattern flaws before installation of circuit components. For example, as disclosed in U.S. Patent 4,152,723, filed May 1, 1979, pattern flaws are detectable using a luminescence technique. In particular, a light source such as a laser is employed to induce a fluorescence in the polymer substrate. Only the portions of the substrate which are not covered by the metallic pattern are illuminated and thus fluoresce. The ambits of the metallic pattern are to an extent determined by sweeping a light beam across the patterned surface and monitoring with conventional equipment, such as a photomultiplier, the fluorescence intensity fluctuations during the sweep. However, this technique does not lead to the reliable observation of pattern flaws.

According to the present invention there is provided a patterned substrate comprising a metal pattern overlying a polymeric substrate, characterised in that to enable detection of flaws in the metal pattern by a step of illuminating the substrate with electromagnetic radiation and detecting the resultant fluorescence from the substrate said substrate includes at least at the surface to be inspected a dye capable of fluorescing substantially homogeneously dispersed in areas to be tested, said dye having a chemical structure represented by a member chosen from the group consisting of (1)

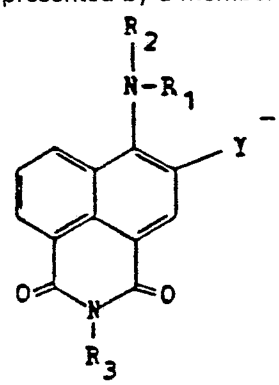

and (2)

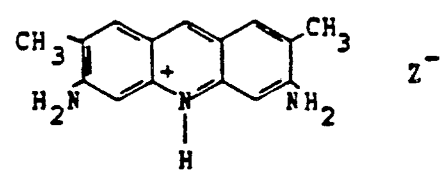

where Y is $SO_3G$, (G is an alkali metal cation), or H, $R_1$ and $R_2$ are individually hydrogen, methyl, or ethyl, and $R_3$ is a lower alkyl (up to 5 carbon atoms), p-tolyl, xylyl, or hydrogen and $Z^-$ is $Cl^-$, $Br^-$, $I^-$, $NO_3^-$ or p-toluenesulfonate.

In a preferred embodiment of the invention, the substrate of the printed circuit board is prepared with a spatially homogeneous distribution of a fluorescent dye having a ring system represented by the formulae

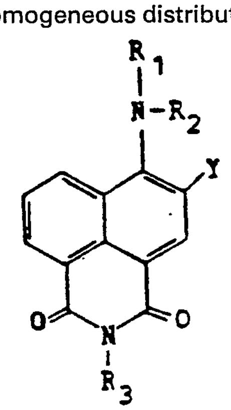

or

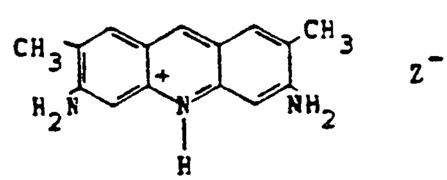

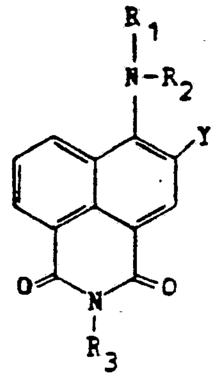

(1) or

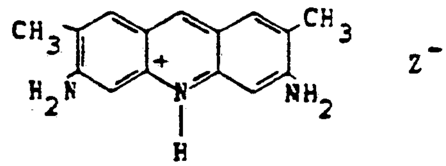

(2)

These resin compositions are easily excited using a He—Cd laser operating, for example, at 442 nm, and fluorescence is stimulated in a conveniently detected spectral region, e.g., 460 to 550 nm. Stimulation of emission and subsequent monitoring utilizing conventional techniques allow detection of pattern flaws as small as 50µm.

Detailed Description

The dye employed in the substrate composition should fulfill certain criteria. The dye should not substantially alter the desired physical or electrical properties of the substrate. For example, it is possible that the use of a highly ionic dye will increase the conductivity of the substrate and thus substantially degrade the insulation resistance necessary to prevent electrical conductivity between disjoint sections of the metallic pattern. Similarly, a dye which degrades the physical integrity of the substrate, e.g., a dye which causes decomposition, or curing or premature aging of the substrate resin through reaction, is also undesirable and should be avoided. Dyes which migrate to the substrate surface and affect the bond to the patterned metal also should be avoided.

The dye should be essentially homogeneously dispersed in the substrate, i.e., the average fluorescence intensity of regions $10^4$ $(\mu m)^2$ in area should vary on average less than 10 percent over all patterned regions of the circuit board. Generally to satisfy this criterion, it is necessary to find a dye which easily disperses directly into the resin, or to find a dye which is co-soluble in the vehicle, e.g., lacquer, employed to produce the circuit board substrate.

The dye should also satisfy certain optical criteria. The fluorescence induced should preferably have a substantial fraction of its intensity below a wavelength of 520 nm. Typically, if fluorescence occurs at higher wavelengths, detection of the fluorescence by using conventional expedients is significantly more difficult. Substantial fluorescence below 460 nm, although acceptable, is generally not produced. For single photon processes, the induced fluorescence occurs at wavelengths which are longer than that of the exciting light. Convenient light sources, such as the He—Cd laser, typically emit at wavelengths above 420 nm. It is preferred to employ a laser since it is easily possible to focus the source to a spot size which is smaller than the smallest metal pattern dimension while preserving intensity. Thus, fluorescence below 420 nm for a convenient light source is generally not presently available.

The observable fluorescence intensity produced by the dye should be at least 10 times greater than the level of fluorescence produced in the substrate in the absence of the dye. Light absorbed farther than 1 mm from the illuminated surface results in fluorescence which is substantially dispersed within the substrate and thus is not readily detected. A dye concentration within 1 mm of the substrate surface of 0.5 to 0.005 percent by weight generally produces the desired absorption and, for typical light sources such as He—Cd laser, yields adequate fluorescence. A control sample is employed to determine the precise dye concentration suitable for a desired absorption level. However, a dye concentration of greater than 1 percent typically produces a dark colored substrate and thus should be avoided.

The dye also should not migrate in the substrate. Such migration leads to inhomogeneities and the previously discussed adverse consequences.

All the previous criteria involved in the subject invention are satisfied by utilizing a dye having a structure based on

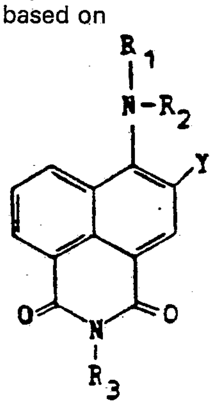

(1) or

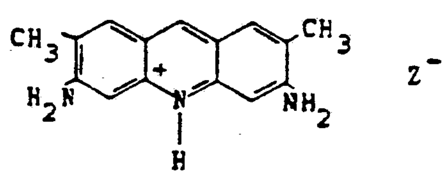

(2)

where Y is $SO_3G$ (G being an alkali metal cation) or H, $R_1$ and $R_2$ are individually hydrogen, methyl or ethyl, $R_3$ is a group such as H, a lower alkyl (up to 5 carbon atoms), p-tolyl, or xylyl, and where $Z^-$ is $Cl^-$, $Br^-$, $I^-$, $NO_3$, or p-toluenesulfonate. Compound (2) is homogeneously dispersible in resins such as epoxy resins, e.g., bisphenol-A diglycidyl ether resins, by the simple expedient of dissolving and/or dispersing the dye in the resin lacquer.

The dyes of composition (1) are also dissolvable and/or dispersible as discussed for the composition (2) dyes. Alternatively, the composition (1) dyes are sufficiently soluble in typical lacquer vehicles such as N,N-dimethylformamide or N-methylpyrrolidone. Therefore, it is possible to form a solution including both the resin and the dye as a lacquer. Similarly, for the composition (1) dye it is preferable to improve the solubility by modifying the parent chromophore (Y, $R_1$, $R_2$, and $R_3$ all being H) by reacting it initially with an excess of bisphenol-A diclycidyl ether. (For example, at least two moles of the bisphenol-A diglycidyl ether are employed for every mole in the dye composition). This reaction yields a much more soluble dye composition having reactive epoxy groups. The dye solution is then combined with the resin in lacquer form. The lacquer is then applied by conventional techniques to a glass mesh to produce a glass fiber reinforced polymer substrate. Since the dye is modified to contain epoxy groups, it reacts as the resin cures and thus is chemically bound within the resin without substantially changing the mechanical or electrical properties of the resin and without changing the fluorescence properties of the dye. Thus, a homogeneous distribution which has long-term stability is advantageously produced. Although this reaction procedure is described in terms of an epoxy resin, it is similarly possible to modify the dye to have reactive groups consistent with the use of other substrate resins.

Often a curing agent is employed to harden the resin, for example, in the case of epoxy resins, curing agents such as dicyandiamide are employed. Substantial destruction of this curing agent before initiation of curing is disadvantageous. The composition (1) and (2) dyes do not substantially react with typical curing agents at nominal temperatures and thus do not significantly decrease their efficacy. Additionally, these dyes do not cause premature hardening of the resin.

### Example 1

The printed circuit board comprises a patterned copper plating formed on a polymer substrate.

The substrate was prepared by spraying an epoxy resin onto a glass fiber reinforcing grid with a dye in the resin solvent or in the resin.

A first or second dye, Acridine Yellow G (the compound previously denominated (2) with Z = Cl) or Brilliant Sulphaflavine (the compound previously denominated (1) with $R_1 = R_2 = H$, $R_3$ = p-tolyl, and Y = $SO_3Na$), was dispersed directly in the solvent and was utilized in the fabrication procedure.

A third dye was alternatively incorporated into the resin. The dye was prepared by adding 4-amino-1,8-naphthalimide (0.24 mole, 50.4 g) and bisphenol-A diglycidyl ether (0.48 mole, 163.2 g) to 1-methyl-2-pyrrolidinone (287 g). The mixture was heated at 155 degree C under nitrogen while being agitated utilizing a mechanical stirrer. This heating and agitation was continued for approximately 6 hours to ensure that the solids had dissolved and then heated and agitated for an additional 2 hours. The solution was then cooled and filtered through Celite® (a filter aid, manufactured by Johns Manville Corporation primarily finely divided $SiO_2$) to yield a solution of concentration 10.1 percent by weight based on the amino-naphthalimide chromophore. The dye solution was then added to a resin solution in dimethylformamide to yield a 0.01 percent by weight concentration of the dye (expressed as the parent chromophore) in the resin.

This example represents a modification of the method of manufacturing printed circuit boards meeting the FR—4 specification of the National Electrical Manufacturer's Association prepared as described by A. N. Cianciarulo and R. L. Webb in *Proceedings of the 23rd Annual Technical Conference,* the Society of the Plastic Industry, Incorporated, 1968, Section 5B, pp. 1—6.

### Example 2

The circuit boards of Example 1 were inspected using a 5 mW He—Cd laser focused to a $\leq$ 20 µm spot size. The fluorescence induced by this laser was detected utilizing a photomultiplier. A cut-off filter placed before the photomultiplier was utilized to remove the dominant wavelengths of the laser. The luminescence intensity observed upon scanning the laser across the board was compared to the pattern expected for a perfectly formed circuit board. Defects as small as 50 µm were observed.

## Claims

1. A patterned substrate comprising a metal pattern overlying a polymeric substrate, characterised in that, to enable detection of flaws in the metal pattern by a step of illuminating the substrate with electromagnetic radiation and detecting the resultant fluorescence from the substrate, said substrate includes at least at the surface to be inspected a dye capable of fluorescing, substantially homogeneously dispersed in areas to be tested, said dye having a chemical structure represented by a member chosen from the group consisting of (1)

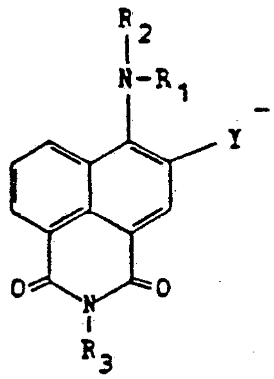

and (2)

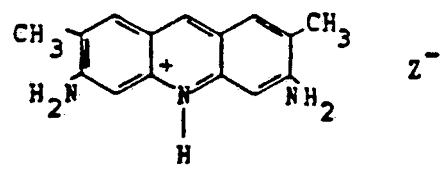

where Y is $SO_3G$, (G is an alkali metal cation), or H, $R_1$ and $R_2$ are individually hydrogen, methyl, or ethyl, and $R_3$ is a lower alkyl (up to 5 carbon atoms) p-tolyl, xylyl, or hydrogen and $Z^-$ is $Cl^-$, $Br^-$, $I^-$, $NO_3^-$ or p-toluenesulfonate.

2. The patterned substrate according to claim 1, characterised in that said dye is chemically bonded to said substrate.

3. The patterned substrate according to claim 1 or 2, characterized in that said dye is distributed essentially homogeneously in said substrate.

4. The patterned substrate according to claims 1, 2, or 3, characterized in that said dye has been modified prior to an incorporation into the substrate with a functional group that makes said dye more soluble in the material employed to form said substrate.

5. The patterned substrate according to any one of preceding claims 1—4, characterized in that said substrate comprises a cured epoxy resin and said dye comprises

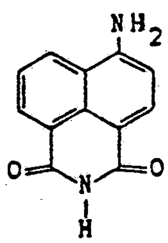

that has been modified to contain an epoxy functional group.

6. The patterned substrate according to any one of preceding claims 1—5, characterized in that said substrate is an electronic circuit board.

7. The patterned substrate according to any one of preceding claims 1—6, characterized in that said pattern comprises a patterned copper layer.

8. The patterned substrate according to claim 7, characterized in that said pattern comprises a patterned copper plating.

**Patentansprüche**

1. Gemustertes Substrat mit einem auf einem polymeren Substrat liegenden Metallmuster, dadurch gekennzeichnet, daß zur Ermöglichung eines Nachweises von Defekten in dem Metallmuster durch Beleuchten des Substrates mit elektromagnetischer Strahlung und Feststellen der vom Substrat resultierenden Fluoreszenz,

— das Substrat wenigstens an der zu inspizierenden Fläche einen in zu prüfenden Gebieten im wesentlichen homogen dispergierten Farbstoff enthält, der zu fluoreszieren vermag, und

— der Farbstoff eine chemische Struktur besitzt, die repräsentiert ist durch ein aus der aus (1)

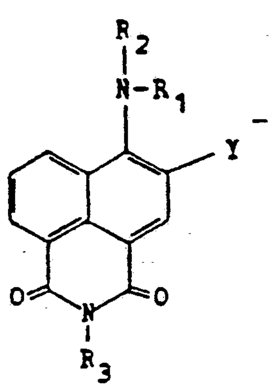

und (2)

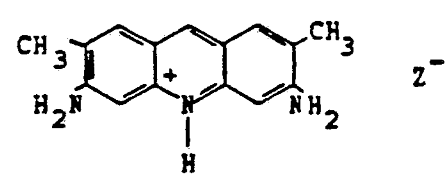

bestehenden Gruppe ausgewähltes Mitglied, worin bedeuten

Y = $SO_3G$ (mit G gleich einem Alkalimetallkation) oder H,

$R_1$ und $R_2$ = individuell Wasserstoff, Methyl oder Ethyl und

$R_3$ = ein niedriger Alkylrest (bis zu 5 Kohlenstoffatome), p-Tolyl, Xylyl oder Wasserstoff und

$Z^-$ = $Cl^-$, $Br^-$, $I^-$, $NO_3^-$ oder p-Toluolsulfonat.

2. Gemustertes Substrat nach Anspruch 1, dadurch gekennzeichnet, daß
— der Farbstoff an das Substrat chemisch gebunden ist.

3. Gemustertes Substrat nach Anspruch 1 oder 2, dadurch gekennzeichnet, daß
— der Farbstoff im wesentlichen homogen in dem Substrat verteilt ist.

4. Gemustertes Substrat nach den Ansprüchen 1, 2 oder 3, dadurch gekennzeichnet, daß
— der Farbstoff vor einem Einbau in das Substrat mit einer funktionellen Gruppe modifiziert worden ist, die den Fabstoff in dem zur Bildung des Substrats verwendeten Material löslicher macht.

5. Gemustertes Substrat nach einem der vorstehenden Ansprüche 1 bis 4, dadurch gekennzeichnet, daß
— das Substrat ein ausgehärtetes Epoxyharz umfaßt und
— der Farbstoff

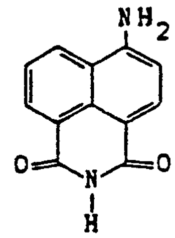

umfaßt, das modifiziert worden ist, um eine funktionelle Epoxygruppe zu enthalten.

6. Gemustertes Substrat nach einem der vorstehenden Ansprüche 1 bis 5, dadurch gekennzeichnet, daß
— das Substrat eine elektronische Schaltungsplatine ist.

7. Gemustertes Substrat nach einem der vorstehenden Ansprüche 1 bis 6, dadurch, gekennzeichnet, daß
— das Muster eine gemusterte Kupferschicht umfaßt.

8. Gemustertes Substrat nach Anspruch 7, dadurch gekennzeichnet, daß
— das Muster eine gemusterte Kupferplattierung umfaßt.

**Revendications**

1. Un substrat dans lequel on a défini un motif, comprenant un motif métallique recouvrant un substrat en polymère, caracterise en ce que, pour permettre la détection de défauts dans le motif métallique, par une opération d'illumination du substrat avec une radiation électromagnétique, et détection de la fluorescence résultante émise par le substrat, ce substrat comprend, au moins à la surface à examiner, un colorant capable de donner lieu à une fluorescence, dispersé de façon pratiquement homogène dans des zones à tester, ce colorant ayant une structure chimique représentée par un membre choisi dans le groupe comprenant (1):

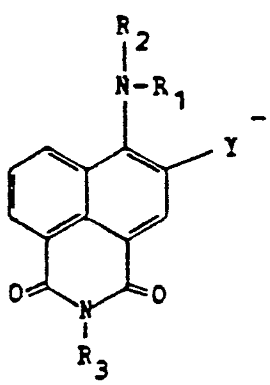

et (2)

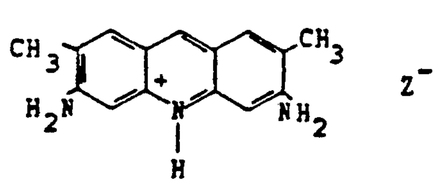

avec les notations suivantes: Y représente $SO_3G$ (G étant un cation de métal alcalin) ou H, $R_1$ et $R_2$ représentent individuellement l'hydrogène, le méthyle ou l'éthyle et $R_3$ représente un alkyle inférieur (jusqu'à 5 atomes de carbone), le p-tolyle, le xylyle ou l'hydrogène et $Z^-$ représente $Cl^-$, $Br^-$, $I^-$, $NO_3^-$ ou le paratoluènesulfonate.

2. Le substrat dans lequel on a défini un motif, selon la revendication 1, caracterise en ce que le colorant est lié chimiquement au substrat.

3. Le substrat dans lequel on a défini un motif, selon la revendication 1 ou 2, caracterise en ce que le colorant est réparti de façon pratiquement homogène dans le substrat.

4. Le substrat dans lequel on a défini un motif, selon les revendications 1, 2 ou 3, caracterise en ce que le colorant a été modifié avant l'incorporation dans le substrat, au moyen d'un groupe fonctionnel qui rend le colorant plus soluble dans la matière employée pour former le substrat.

5. Le substrat dans lequel on a défini un motif, selon l'une quelconque des revendications 1—4 précédentes, caracterise en ce que le substrat consiste en une résine époxyde soumise à une opération de maturation et le colorant comprend la substance:

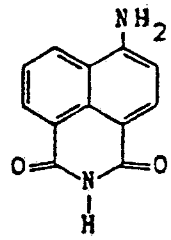

qui a été modifiée de façon à contenir un groupe fonctionnel époxyde.

6. Le substrat dans lequel on a défini un motif, selon l'une quelconque des revendications 1—5 précédentes, caracterise en ce que le substrat est une carte de circuit électronique.

7. Le substrat dans lequel on a défini un motif, selon l'une quelconque des revendications 1—6 précédentes, caracterise en ce que le motif consiste en une couche de cuivre dans laquelle on a défini un motif.

8. Le substrat dans lequel on a défini un motif, selon la revendication 7, caracterise en ce que le motif consiste en un placage de cuivre dans lequel on a défini un motif.